**Europäisches Patentamt**

**European Patent Office**

**Office européen des brevets**

(19)

(11) Veröffentlichungsnummer : **0 123 955**
**B1**

(12) **EUROPÄISCHE PATENTSCHRIFT**

(45) Veröffentlichungstag der Patentschrift :
**19.08.87**

(51) Int. Cl.⁴ : **G 11 C 15/00**, G 06 F 12/08

(21) Anmeldenummer : **84103726.0**

(22) Anmeldetag : **04.04.84**

(54) **Schaltungsanordnung für Speichereinrichtungen zur Speicherung von Daten mit Gültigkeitszeichen.**

(30) Priorität : **06.04.83 DE 3312391**

(43) Veröffentlichungstag der Anmeldung :
**07.11.84 Patentblatt 84/45**

(45) Bekanntmachung des Hinweises auf die Patenterteilung : **19.08.87 Patentblatt 87/34**

(84) Benannte Vertragsstaaten :
**AT BE CH FR GB IT LI NL SE**

(56) Entgegenhaltungen :
**IBM TECHNICAL DISCLOSURE BULLETIN, Band 13, Nr. 11, April 1971, Seiten 3380-3381, New York, USA; J.R. DAILEY et al.: "Associative information manipulator"**
**IBM TECHNICAL DISLOSURE BULLETIN, Band 14, Nr. 2, Juli 1971, Seiten 358-361, New York, USA; J.G. EARLE et al.: "Multiprocessing checkpoint retry"**
**INFORMATION PROCESSING 68, Proceedings of the I.F.I.P. Congres 68 organised by the International Federation for Information Processing, Edingburgh, 5.-10. August 1968, Seiten 796-800, North-Holland Publishing Company, 1969, Amsterdam, NL; D.A. ASPINALL et al.: "Associative memories in large computer systems"**

(73) Patentinhaber : **Siemens Aktiengesellschaft Berlin und München**
**Wittelsbacherplatz 2**
**D-8000 München 2 (DE)**

(72) Erfinder : **Bräuer, Gerald, Dipl.-Ing.**
**Robert-Koch-Strasse 28**
**D-8012 Ottobrunn (DE)**

# Beschreibung

Die Erfindung betrifft eine Schaltungsanordnung für Speichereinrichtungen, gemäß dem Oberbegriff des Patentanspruches.

In Datenverarbeitungseinrichtungen werden zu speichernde Daten häufig mit einem Gültigkeitskennzeichen versehen, das angibt, ob die zugehörigen Daten gültig sind und damit für die weitere Verarbeitung zur Verfügung stehen. Als Kennzeichen verwendet man allgemein eine Bitstelle, die bei Inhalt « 1 » die Gültigkeit anzeigt und bei Inhalt « 0 » die zugehörigen Daten ungültig erklärt.

Als Beispiel für derartige Speichereinrichtungen mag ein Adressenübersetzungsspeicher dienen, der zwischen 64 und 1 024 Einträge enthalten kann. Sollen nun alle Einträge auf einmal für ungültig erklärt werden, dann müssen alle Einträge nacheinander angesteuert und das jeweils zugehörige Gültigkeitsbit auf Null gesetzt weden. Das erfordert einen großen Zeitaufwand, der vielfach nicht tragbar ist.

Aufgabe der Erfindung ist es daher, eine Schaltungsanordnung der eingangs genannten Art zu schaffen, die mit nur geringem Mehraufwand an Bauteilen den Zeitaufwand für das eindeutige Ungültigerklären aller Daten wesentlich verringert. Diese Aufgabe wird durch die kennzeichnenden Merkmale des Patentanspruches gelöst.

Anstelle des bisher üblichen Gültigkeitsbits wird gemäß der Erfindung ein von einem zyklisch fortschaltbaren Zähler abgeleitetes mehrstelliges Gültigkeitskennzeichen verwendet, das die zugehörigen Daten nur für gültig erklärt, wenn der Zählerstand sich nicht verändert hat und mit dem abgespeicherten Gültigkeitskennzeichen übereinstimmt. Folglich kann man mit Fortschalten des Zählers um einen Schritt alle zu einem vorgegebenen Zeitpunkt gültigen Daten mit einem Schlag für ungültig erklären, ohne daß jedes einzelne Gültigkeitskennzeichen nacheinander zu ändern ist.

Um dabei zu verhindern, daß die einzelnen Gültigkeitskennzeichen durch Fortschalten des Zählers für ungültig erklärte Daten wegen des fortschreitenden Zählerzyklusses wieder gültig werden lassen, wird lediglich einmal während eines Zählzyklusses, nämlich bei Erreichen der Nullstellung des Zählers, der Steuerungsablauf erweitert, und es werden alle gespeicherten Gültigkeitskennzeichen einzeln nacheinander aufgerufen und durch den augenblicklichen Zählerstand Null ersetzt. Durch einen unmittelbar nachfolgenden erneuten Zählschritt des Zählers sind dann alle Daten als ungültig gekennzeichnet und es ist so auf einfache Weise ausgeschlossen, daß ungültige Daten bis zum Erreichen der nächsten Zählernullstellung zwangsläufig wieder gültig werden, wenn sie nicht ausdrücklich durch Änderung des Gültigkeitskennzeichens für gültig erklärt werden.

Je nach Anwendungsfall und abhängig von der Anzahl der in eine Speichereinrichtung eintragbaren Daten kann die Zählkapazität des Zählers entsprechend günstig gewählt werden.

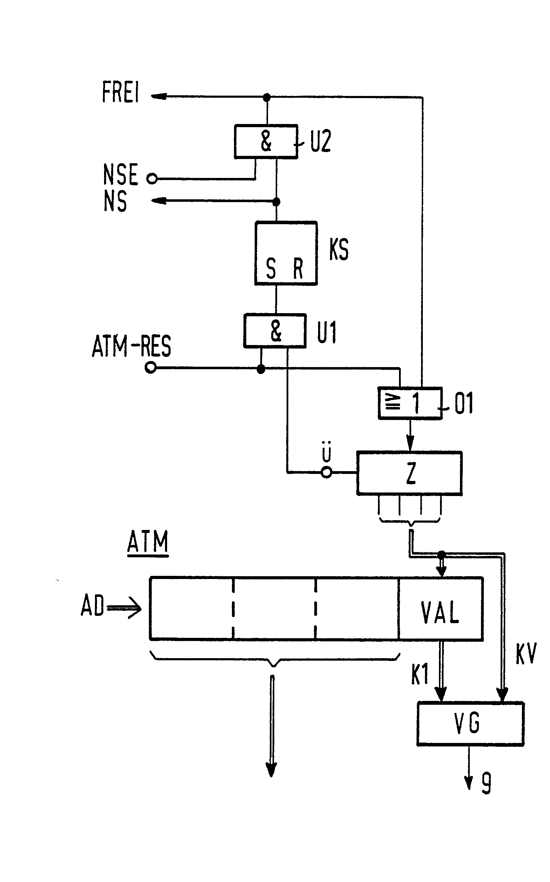

Einzelheiten der Erfindung seien nachfolgend anhand eines in der Zeichnung dargestellten Ausführungsbeispieles näher erläutert.

Die einzige Figur der Zeichnung zeigt in schematischer Darstellung eine mit der Adresse AD ansteuerbare Eintragszeile eines Adressenübersetzungsspeichers ATM mit dem Abschnitt VAL für das Gültigkeitszeichen K1, das bei jeder Ansteuerung des Eintrags dem Vergleicher VG zugeführt wird. Als Vergleichskennzeichen KV dient der vom zyklisch arbeitenden Zähler Z gelieferte augenblickliche Zählerstand. Stimmen beide Kennzeichen überein, sind die im angesteuerten Eintrag enthaltenen, aber nicht näher bezeichneten Daten gültig, was in an sich bekannter Weise mit dem Ausgangssignal g des Vergleichers VG an die die im Eintrag enthaltenen Daten weiter verarbeitende, nicht gezeigte Einrichtung gemeldet wird.

Sind neue Daten in den Speicher ATM einzutragen, so wird das zugehörige Gültigkeitskennzeichen vom Ausgang des Zählers Z abgeleitet und in den zugehörigen Abschnitt VAL übertragen.

Der Zähler Z wird jeweils nur dann um einen Schritt fortgeschaltet, wenn alle Einträge des Speichers ATM für ungültig zu erklären sind. Dies erfolgt durch das Signal ATM-RES. Infolge der zyklischen Fortschaltung des Zählers Z weicht das Vergleichskennzeichen KV nach einer Zählerfortschaltung immer von den in den Abschnitten VAL des Speichers ATM gespeicherten Gültigkeitskennzeichen ab. Alle Einträge sind daher mit einem Schlag ungültig, ohne daß die einzelnen Einträge nacheinander — wie bisher — anzusteuern und die Gültigkeitskennzeichen zu ändern sind.

Lediglich beim Erreichen der Nullstellung des Zählers Z ist diese Voraussetzung nicht mehr erfüllt, da die gespeicherten Gültigkeitskennzeichen alle Zählwerte aufweisen und daher mit fortlaufender Fortschaltung des Zählers wieder erreicht werden können, so daß ungültige Daten wieder gültig werden. Um dies zu vermeiden, ist es erforderlich — allerdings nur in diesem Ausnahmefall — alle Einträge des Speichers ATM einzeln anzusteuern und die Gültigkeitskennzeichen in Übereinstimmung mit der Nullstellung des Zählers Z ebenfalls auf Null zu setzen. Durch einen nachfolgenden zusätzlichen Zählschritt für den Zähler Z wird dann der alte Ausgangszustand wieder hergestellt.

Die dazu erforderliche Umsteuerung wird durch das mit Erreichen der letzten Zählstellung vor der Nullstellung des Zählers Z ausgelöste Überlaufsignal ü eingeleitet, das mit dem danach die Nullstellung herbeiführenden Fortschaltesignal ATM-RES über das UND-Glied U1 eine Kippstufe KS setzt. Diese löst mit dem Signal NS die Ansteuerung aller Einträge im Speicher ATM aus, wobei in alle Abschnitte VAL der Zählerstand Null eingetragen wird. Das Ende dieser Eintragsänderung wird mit dem Signal NSE gemeldet, das über das UND-Glied U2 in Verbindung mit der gesetzten Kippstufe dann einen weiteren Fortschalteimpuls für den Zähler auslöst, der diesem über das ODER-Glied O1 zugeführt wird. Gleichzeitig wird die Kippstufe KS zurückgesetzt und der Speicher für den normalen Arbeitsbetrieb wieder freigegeben.

Bei m Einträgen im Speicher ATM und einer Zählkapazität von n Zählschritten des Zählers Z sind also statt n · m Speicheransteuerungen für das Nullsetzen der Gültigkeitseinträge nur m Ansteuerungen erforderlich, und zwar jeweils nach n Zählschritten.

## Patentanspruch

Schaltungsanordnung für Speichereinrichtungen, in denen den gespeicherten Daten Gültigkeitskennzeichen zugeordnet sind, die die Gültigkeit bzw. Nichtgültigkeit der jeweils zugehörigen Daten anzeigen und unabhängig von den Daten änderbar sind, dadurch gekennzeichnet, daß ein zyklisch fortschaltbarer Zähler (Z) vorgesehen ist, der ein seinem Zählerstand entsprechendes mehrstelliges Kennzeichen liefert, daß bei Übernahme gültiger Daten in die Speichereinrichtung (ATM) jeweils das vom Zähler (Z) gelieferte mehrstellige Kennzeichen als Gültigkeitskennzeichen (K1) den Daten zugesetzt und abgespeichert wird, daß in der Speichereinrichtung (ATM) enthaltene Daten jeweils nur dann als gültig gewertet und für die weitere Verarbeitung freigegeben werden, wenn das zugehörige Gültigkeitskennzeichen (K1) und das vom Zähler (Z) als Vergleichskennzeichen (KV) gelieferte Kennzeichen übereinstimmen, daß der Zähler (Z) nur dann um einen Schritt fortgeschaltet wird, wenn alle vorher gültigen Daten für ungültig zu erklären sind, und daß jeweils mit Erreichen der Nullstellung des Zählers (Z) alle in der Speichereinrichtung (ATM) gespeicherten Gültigkeitskennzeichen (K1) nacheinander durch das vom Zähler (Z) gelieferte Kennzeichen ersetzt werden und der Zähler (Z) danach um einen Schritt weitergeschaltet wird.

## Claim

A circuit arrangement for storage devices in which the stored data items are assigned validity characteristics which indicate the validity or non-validity of the assigned data and which can be changed in dependence upon the data, characterised in that a counter (Z) is provided which can be stepped on in cyclic fashion and supplies a multi-digit characteristic corresponding to its count ; that transfer of valid data into the storage device (ATM) causes the multi-digit characteristic supplied by the counter (Z) to be added to the data as a validity characteristic (K1) and is stored ; that items of data contained in the storage device (ATM) are evaluated as valid and released for further processing only when the assigned validity characteristic (K1) and the characteristic supplied by the counter (Z) as a comparison characteristic (KV) are identical ; that the counter (Z) is stepped on by one step only when all the previously valid data items are to be declared invalid ; and that whenever the zero count of the counter (Z) is reached, all the validity characteristics (K1) stored in the storage device (ATM) are consecutively replaced by the characteristic supplied by the counter (Z) and the counter (Z) is then stepped on by one step.

## Revendication

Montage pour des dispositifs à mémoire, dans lesquels on associe aux données mémorisées des caractères de validation qui indiquent la validité ou l'invalidité des données associées, et qui sont susceptibles d'être modifiés indépendamment des données, caractérisé par le fait, qu'il est prévu un compteur (Z) susceptible d'être avancé cycliquement, et qui forme un caractère à plusieurs chiffres, que lors de la prise en charge des données validées dans le dispositif à mémoire (ATM), le caractère à plusieurs chiffres fourni par le compteur (Z) est ajouté, en tant que caractère de validation (K1), aux données et est mémorisé, que les données contenues dans le dispositif à mémoire (ATM) ne sont évaluées comme étant valides et sont autorisées pour le post-traitement seulement si le caractère de validation (K1) et le caractère fourni par le compteur (Z), en tant que caractère de comparaison (KV), coïncident, que le compteur (Z) n'est avancé d'un pas que si toutes les données antérieures validées doivent être déclarées invalides, et que lorsque la position zéro du compteur (Z) est atteinte, tous les caractères de validation (K1) qui sont mémorisés dans le dispositif à mémoire (ATM) sont remplacés successivement par le caractère fourni par le compteur (Z), et que le compteur (Z) est ensuite avancé d'un pas.